# EUROPEAN PATENT APPLICATION

(11) **EP 4 481 448 A1**
(43) Date of publication of application: **25.12.2024**
(21) Application number: 23756444.8
(22) Date of filing: 16.02.2023
(51) Int. Cl.: G02B 5/22, C08F 220/20, C09B 3/14, C09B 67/20, G02B 5/20, G03F 7/004

(54) **INFRARED PASS FILTER, COLORING COMPOSITION, FILTER FOR SOLID-STATE IMAGING ELEMENT, AND SOLID-STATE IMAGING ELEMENT**

(30) Priority: 16.02.2022 JP 2022022316
(71) Applicant: Toppan Holdings Inc., Tokyo 110-0016 (JP)
(72) Inventor: HIROTA Tetsuya, Tokyo 110-0016 (JP); TAKUBO Chiharu, Tokyo 110-0016 (JP)
(74) Representative: Hoffmann Eitle
(86) International application number: PCT/JP2023/005467
(87) International publication number: WO 2023/157919

(57) **Abstract**

The infrared light pass filter includes a colorant, an indium tin oxide, and a polymer. The infrared light pass filter has an average transmittance of 30% or less in a first wavelength range of 400 nm or greater and 800 nm or less, an average transmittance of 75% or more in a second wavelength range of 900 nm or greater and 1100 nm or less, and an average transmittance of 55% or less in a third wavelength range of 1300 nm or greater and 2500 nm or less.

## Description

### [Technical Field]

The present disclosure relates to an infrared light pass filter, a coloring composition, a filter for solid-state image sensors, and a solid-state image sensor.

### [Background Art]

A solid-state image sensor such as a CMOS image sensor or a CCD image sensor includes a photoelectric conversion device that converts the intensity of light into electric signals. A solid-state image sensor includes, in addition to a plurality of photoelectric conversion devices, color filters positioned on the photoelectric conversion devices for corresponding colors, and an infrared light pass filter positioned on the photoelectric conversion device for infrared light.

The infrared light pass filter blocks visible light detectable by the photoelectric conversion device for infrared light thereby to enhance the detection accuracy of infrared light by the photoelectric conversion device for infrared light. In an example of the infrared light pass filter, the maximum transmittance to light contained in a first wavelength range of 400 nm or more and 700 nm or less is 15% or less, and the minimum transmittance of light contained in a second wavelength range of 850 nm or more and 1100 nm or less is 85% or less. Accordingly, the infrared light pass filter selectively transmits light in the second wavelength range to light in the first wavelength range (for example, see PTL 1).

### [Citation List]

### [Patent Literature]

PTL 1: JP 2016-177273 A

### [Summary of the Invention]

### [Technical Problem]

In the above-described infrared light pass filter, the wavelength selectivity of the infrared light pass filter is enhanced by lowering the transmittance to light of the first wavelength range which is a wavelength shorter than the second wavelength range that is selectively allowed to pass through. On the other hand, light entering the infrared light pass filter includes light having a wavelength longer than 1100 nm, and therefore the infrared light pass filter is also required to be able to selectively transmit light in the second wavelength range compared to light having a wavelength longer than the second wavelength range.

### [Solution to Problem]

An aspect of an infrared light pass filter includes a colorant, an indium tin oxide, and a polymer. The infrared light pass filter has an average transmittance of 30% or less in a first wavelength range of 400 nm or greater and 800 nm or less, an average transmittance of 75% or more in a second wavelength range of 900 nm or greater and 1100 nm or less, and an average transmittance of 55% or less in a third wavelength range of 1300 nm or greater and 2500 nm or less.

An aspect of a coloring composition includes: a colorant that absorbs visible light; an indium tin oxide; and a polymerizable compound. In the total solid content of the coloring composition, the content of the indium tin oxide is 10% by weight or more and 30% by weight or less.

An aspect of a filter for solid-state image sensors includes a color filter and the above-described infrared light pass filter.

An aspect of a solid-state image sensor includes the above-described filter for solid-state image sensors, a first photoelectric conversion device covered by the color filter, and a second photoelectric conversion device covered by the infrared light pass filter.

### [Brief Description of the Drawings]

Fig. 1 is an exploded perspective view showing a layer structure in an embodiment of a solid-state image sensor.
Fig. 2 is a diagram showing a graph illustrating a relationship between a content of an indium tin oxide and an average transmittance in a third wavelength range and a graph illustrating a relationship between a content of an indium tin oxide and an area of a residue.

### [Description of Embodiments]

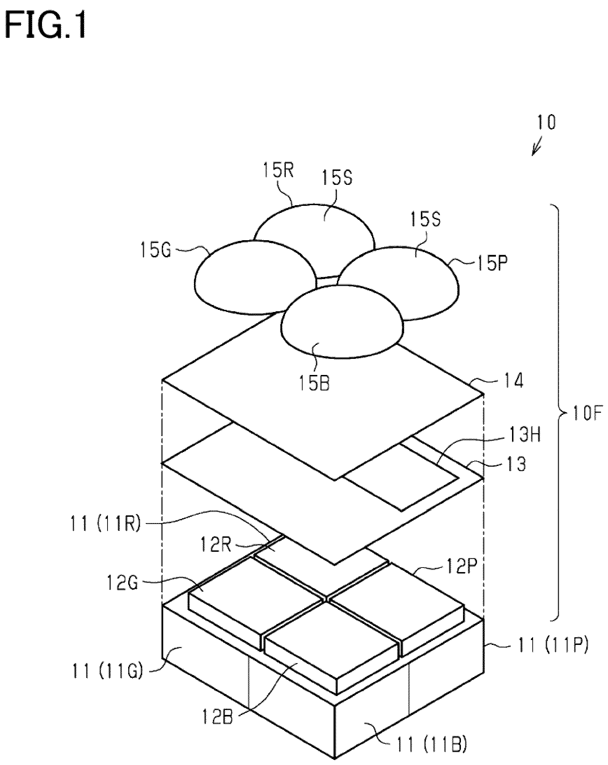

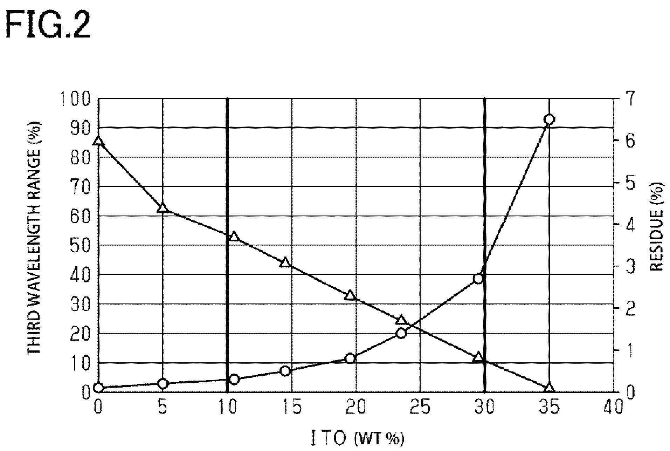

With reference to Fig. 1 and Fig. 2, an embodiment of an infrared light pass filter, a coloring composition, a filter for solid-state image sensors, and a solid-state image sensor will be described. Note that in the present embodiment, infrared light is light having a wavelength in the range of 0.7 µm or more and 1 mm or less. Near-infrared light contains, of infrared light, wavelengths in the range of 800 nm or more and 1100 nm or less and wavelengths in the range of 1300 nm or more and 2500 nm or less. Further, visible light is light having a wavelength of 400 nm or more and 800 nm or less. Note that hereinafter, the wavelength range of 400 nm or more and 800 nm or less is referred to as a first wavelength range, the wavelength range of 900 nm or more and 1100 nm or less is referred to as a second wavelength range, and the wavelength range of 1300 nm or more and 2500 nm or less is referred to as a third wavelength range.

Further, in the present embodiment, (meth)acrylate means at least one of acrylate and methacrylate. That is, (meth)acrylate may mean both acrylate and methacrylate, may mean only acrylate, or may mean only methacrylate. Further, in the present embodiment, C.I. means a color index.

### [Solid-state image sensor]

With reference to Fig. 1, a solid-state image sensor will be described. Fig. 1 is a schematic configuration view showing layers separated in a part of a solid-state image sensor.

As shown in Fig. 1, a solid-state image sensor 10 includes a filter for solid-state image sensors 10F and a plurality of photoelectric conversion devices 11. The plurality of photoelectric conversion devices 11 includes a photoelectric conversion device for red color 11R, a photoelectric conversion device for green color 11G, a photoelectric conversion device for blue color 11B, and a photoelectric conversion device for infrared light 11P. The corresponding-color photoelectric conversion devices 11R, 11G, and 11B measure the intensities of visible light having specific wavelengths matching the respective photoelectric conversion devices 11R, 11G, and 11B. Each photoelectric conversion device for infrared light 11P measures the intensity of infrared light.

The solid-state image sensor 10 includes a plurality of photoelectric conversion devices for red color 11R, a plurality of photoelectric conversion devices for green color 11G, a plurality of photoelectric conversion devices for blue color 11B, and a plurality of photoelectric conversion devices for infrared light 11P. Note that in Fig. 1, the repeating unit of the photoelectric conversion devices 11 in the solid-state image sensor 10 is shown for convenience of illustration. The photoelectric conversion device for red color 11R, the photoelectric conversion device for green color 11G, and the photoelectric conversion device for blue color 11B are examples of a first photoelectric conversion device, and the photoelectric conversion device for infrared light 11P is an example of a second photoelectric conversion device.

The filter for solid-state image sensors 10F includes a plurality of color filters for visible light, an infrared light pass filter 12P, an infrared light cut filter 13, a barrier layer 14, a plurality of microlenses for visible light, and a microlens for infrared light 15P.

The color filters for visible light are constituted by a filter for red color 12R, a filter for green color 12G, and a filter for blue color 12B. The filter for red color 12R is positioned on the light-incidence side to the photoelectric conversion device for red color 11R. The filter for green color 12G is positioned on the light-incidence side to the photoelectric conversion device for green color 11G. The filter for blue color 12B is positioned on the light-incidence side to the photoelectric conversion device for blue color 11B.

Note that the corresponding color filters 12R, 12G, and 12B may be directly formed on the photoelectric conversion devices 11R, 11G, and 11B, respectively, as shown in Fig. 1, or planarization layers may be positioned between the filters for the corresponding colors 12R, 12G, or 12B and the photoelectric conversion devices 11R, 11G, and 11B, respectively. This can enhance adhesion of the corresponding color filters 12R, 12G, and 12B to the photoelectric conversion devices 11R, 11G, and 11B, respectively.

The infrared light pass filter 12P is positioned on the light-incidence side of the photoelectric conversion device for infrared light 11P. The infrared light pass filter 12P shields the photoelectric conversion device for infrared light 11P from visible light detectable by the photoelectric conversion device for infrared light 11P. This can enhance the detection accuracy of infrared light by the photoelectric conversion device for infrared light 11P. The infrared light detectable by the photoelectric conversion device for infrared light 11P is, for example, near-infrared light.

The thickness of the infrared light pass filter 12P may be thicker than the thicknesses of the filters for the corresponding colors 12R, 12G, and 12B. In this case, non-transmission of visible light in the infrared light pass filter 12P can be enhanced.

The infrared light cut filter 13 is positioned on the light-incidence side to the filters for the corresponding colors 12R, 12G, and 12B. The infrared light cut filter 13 includes a through hole 13H. When seen from a viewpoint facing a plane on which the infrared light cut filter 13 extends, the infrared light pass filter 12P is positioned in a region defined by the through hole 13H. On the other hand, when seen from a viewpoint facing a plane on which the infrared light cut filter 13 extends, the infrared light cut filter 13 is positioned on the filter for red color 12R, the filter for green color 12G, and the filter for blue color 12B.

The infrared light cut filter 13 contains an infrared light absorbing dye. The infrared light absorbing dye has a maximum value in the absorptivity of infrared light at any wavelength contained in near-infrared light. Therefore, near-infrared light passing through the infrared light cut filter 13 can be reliably absorbed by the infrared light cut filter 13. Accordingly, near-infrared light detectable by the photoelectric conversion devices 11 for the corresponding colors can be sufficiently cut by the infrared light cut filter 13. The infrared light cut filter 13 can have a thickness of, for example, 300 nm or more and 3 µm or less.

When the base of each of the above-described microlenses is uneven, accuracy in processing the microlens may deteriorate. From the viewpoint of enhancing the evenness of the base of the microlens, the total of the thickness of the filters for the corresponding colors 12R, 12G, and 12B and the thickness of the infrared light cut filter 13 is preferably substantially equal to the thickness of the infrared light pass filter 12P.

The barrier layer 14 suppresses transmission of an oxidation source to the infrared light cut filter 13. The oxidation source may be oxygen, water, or the like. The oxygen transmittance of the barrier layer 14 is preferably, for example, 5.0 cc/m²/day/atm or less. The oxygen transmittance is a value according to JIS K 7126:2006. Since the oxygen transmittance is set to 5.0 cc/m²/day/atm or less, the barrier layer 14 prevents an oxidation source from reaching the infrared light cut filter 13. Therefore, the infrared light cut filter 13 is unlikely to be oxidized by an oxidation source. This can improve the light resistance of the infrared light cut filter 13.

A material for forming the barrier layer 14 is an inorganic compound. A material for forming the barrier layer 14 is preferably a silicon compound. A material for forming the barrier layer 14 may be, for example, at least one selected from the group consisting of silicon nitride, silicon oxide, and silicon oxynitride.

The microlenses are constituted by a microlens for red color 15R, a microlens for green color 15G, a microlens for blue color 15B, and the microlens for infrared light 15P. The microlens for red color 15R is positioned on the light-incidence side of the filter for red color 12R. The microlens for green color 15G is positioned on the light-incidence side of the filter for green color 12G. The microlens for blue color 15B is positioned on the light-incidence side of the filter for blue color 12B. The microlens for infrared light 15P is positioned on the light-incidence side of the infrared light pass filter 12P.

Each of the microlenses 15R, 15G, 15B, and 15P includes an incidence surface 15S. Each of the microlenses 15R, 15G, 15B, and 15P has a refractive index difference from atmospheric air for collecting light entering the entering surface 15S toward each of the photoelectric conversion devices 11R, 11G, 11B, and 11P. Each of the microlenses 15R, 15G, 15B, and 15P contains a transparent resin.

### [Production method of filter for solid-state image sensors]

In the production method of the filter for solid-state image sensors, the filters for the corresponding colors 12R, 12G, and 12B are formed first. Each of the filters for the corresponding colors 12R, 12G, and 12B is formed by formation of a coating film that contains a photosensitive coloring composition for each of the filters for the corresponding colors 12R, 12G, and 12B and patterning of the coating film using a photolithographic method. For example, a coating film that contains a photosensitive composition for red color is formed by coating with a coating liquid that contains a photosensitive composition for red color and drying of the coating film. The filter for red color 12R is formed through exposure and development of a coating film that contains a photosensitive composition for red color in a region corresponding to the filter for red color 12R. Note that the filter for green color 12G and the filter for blue color 12B are also formed by a method similar to the filter for red color 12R.

A coloring contained in the photosensitive coloring composition of the filter for red color 12R, the filter for green color 12G, and the filter for blue color 12B may be an organic pigment or an inorganic pigment. The organic pigment and the inorganic pigment may be used individually, or two or more types of the organic pigment and the inorganic pigment may be mixed. Since the pigment used as the colorant is preferably high in color development, high in heat resistance, especially thermal decomposition resistance, an organic pigment is preferable.

The organic pigment may include a phthalocyanine-based pigment, an azo-based pigment, an anthraquinone-based pigment, a quinacridone-based pigment, a dioxazine-based pigment, an anthanthrone-based pigment, an indanthrone-based pigment, a perylene-based pigment, a thioindigo-based pigment, an isoindoline-based pigment, a quinophthalone-based pigment, and a diketopyrrolopyrrole-based pigment.

A colorant used for the photosensitive coloring composition of the filter for red color 12R may be a red pigment. Examples of the red pigment may include C.I. Pigment Red 7, 9, 14, 41, 48:1, 48:2, 48:3, 48:4, 81:1, 81:2, 81:3, 97, 122, 123, 146, 149, 168, 177, 178, 180, 184, 185, 187, 192, 200, 202, 208, 210, 215, 216, 217, 220, 223, 224, 226, 227, 228, 240, 246, 254, 255, 264, and 272, and C.I. Pigment Orange 36, 43, 51, 55, 59, 61, 71, and 73.

Note that the photosensitive coloring composition of the filter for red color 12R may contain a pigment for toning as necessary. Examples of the pigment for toning may include C.I. Pigment Yellow 1, 2, 3, 4, 5, 6, 10, 12, 13, 14, 15, 16, 17, 18, 24, 31, 32, 34, 35, 35:1, 36, 36:1, 37, 37:1, 40, 42, 43, 53, 55, 60, 61, 62, 63, 65, 73, 74, 77, 81, 83, 93, 94, 95, 97, 98, 100, 101, 104, 106, 108, 109, 110, 113, 114, 115, 116, 117, 118, 119, 120, 123, 126, 127, 128, 129, 138, 139, 147, 150, 151, 152, 153, 154, 155, 156, 161, 162, 164, 166, 167, 168, 169, 170, 171, 172, 173, 174, 175, 176, 177, 179, 180, 181, 182, 185, 187, 188, 193, 194, 198, 199, 213, and 214.

A colorant used for the photosensitive coloring composition of the filter for green color 12G may be a green pigment. Examples of the green pigment may include C.I. Pigment Green 7, 10, 36, 37, 58, and 59. The photosensitive coloring composition of the filter for green color 12G may contain a pigment for toning as necessary. Examples of the pigment for toning may include C.I. Pigment Yellow 1, 2, 3, 4, 5, 6, 10, 12, 13, 14, 15, 16, 17, 18, 24, 31, 32, 34, 35, 35:1, 36, 36:1, 37, 37:1, 40, 42, 43, 53, 55, 60, 61, 62, 63, 65, 73, 74, 77, 81, 83, 93, 94, 95, 97, 98, 100, 101, 104, 106, 108, 109, 110, 113, 114, 115, 116, 117, 118, 119, 120, 123, 126, 127, 128, 129, 138, 139, 147, 150, 151, 152, 153, 154, 155, 156, 161, 162, 164, 166, 167, 168, 169, 170, 171, 172, 173, 174, 175, 176, 177, 179, 180, 181, 182, 185, 187, 188, 193, 194, 198, 199, 213, and 214.

A colorant used for the photosensitive coloring composition of the filter for blue color 12B may be a blue pigment. Examples of the blue pigment may include C.I. Pigment Blue 15, 15:1, 15:2, 15:3, 15:4, 15:6, 16, 22, 60, 64, and 81. The blue pigment is preferably C.I. Pigment Blue 15:6.

The infrared light pass filter 12P is formed by formation of a coating film that contains a coloring composition for the infrared light pass filter and patterning of the coating film using a photolithographic method, similarly to the above-described filter for red color 12R. The coating film is formed by coating with a coating liquid that contains a coloring composition for the infrared light pass filter and drying of the coating liquid. The infrared light pass filter 12P is formed through exposure and development of the coating film in a region corresponding to the infrared light pass filter 12P. Note that ultraviolet light, for example, light having a wavelength of 365 nm, is used for exposure of the coating film.

The infrared light cut filter 13 is formed by deposition using a liquid phase deposition method such as a coating method. The infrared light cut filter 13 is formed of a composition that contains an infrared light absorbing dye and a transparent resin. Examples of the infrared light absorbing dye may include an anthraquinone-based dye, a cyanine-based dye, a phthalocyanine-based dye, a dithiol-based dye, a diimonium-based dye, a squarylium-based dye, and a croconium-based dye. Examples of the transparent resin may include an acryl-based resin, a polyamide-based resin, a polyimide-based resin, a polyurethane-based resin, a polyester-based resin, a polyether-based resin, a polyolefin-based resin, a polycarbonate-based resin. a polystyrene-based resin, and a norbornene-based resin.

Note that the photosensitive coloring compositions for the corresponding colors and the coloring composition for the infrared light cut filter may further contain a binder resin, a photopolymerization initiator, a polymerization inhibitor, a polymerizable compound, an organic solvent, a leveling agent, and the like.

Further, in performing patterning of the coating film by a photolithographic method, it is preferable to use an exposure apparatus such as a stepper and a photomask having a prescribed pattern. The coating film can be patterned by exposing the coating film through the photomask and thereafter removing an unexposed portion in the coating film using a developer. The developer preferably exhibits alkalinity. The alkaline developer may be an inorganic alkaline developer or an organic alkaline developer. Examples of the inorganic alkaline developer may include sodium hydroxide, potassium hydroxide, and sodium carbonate. An example of the organic alkaline developer may include tetrahydroxyammonium. Further, from the viewpoint of enhancing the wettability of the developer to the coating film, the developer preferably contains a surfactant.

The barrier layer 14 is formed by a vapor deposition method such as a sputtering method, a CVD method, or an ion plating method or by deposition using a liquid phase deposition method such as a coating method. The barrier layer 14 formed of silicon oxide is formed, for example, through deposition by sputtering using a target including silicon oxide to a substrate on which the infrared light cut filter 13 is formed. The barrier layer 14 formed of silicon oxide is formed, for example, through deposition by CVD using silane and oxygen to a substrate on which the infrared light cut filter 13 is formed. The barrier layer 14 formed of silicon oxide may be formed, for example, by coating with a coating liquid that contains polysilazane, modification, and drying of the coating film. The layer structure of the barrier layer 14 may be a single layer structure including a single compound, a laminate structure of layers including a single compound, or a laminate structure of layers including compounds different from one another.

Each of the microlenses 15R, 15G, 15B, and 15P is formed by formation of a coating film that contains a transparent resin, patterning of the coating film using a photolithographic method, and reflow by a heat treatment. Examples of the transparent resin include an acryl-based resin, a polyamide-based resin, a polyimide-based resin, a polyurethane-based resin, a polyester-based resin, a polyether-based resin, a polyolefin-based resin, a polycarbonate-based resin. a polystyrene-based resin, and a norbornene-based resin.

### [Infrared light pass filter]

The infrared light pass filter 12P of the present disclosure contains a colorant, indium tin oxide (ITO), and a polymer. The polymer is an organic high molecular compound generated by polymerization of a polymerizable compound. In the infrared light pass filter 12P, the average transmittance in a first wavelength range of 400 nm or more and 800 nm or less is 30% or less, the average transmittance in a second wavelength range of 900 nm or more and 1100 nm or less is 75% or more, and the average transmittance in a third wavelength range of 1300 nm or more and 2500 nm or less is 55% or less.

According to the infrared light pass filter 12P, the infrared light pass filter 12P contains ITO so that the average transmittance in the third wavelength range can be lowered. Accordingly, the infrared light pass filter 12P can selectively transmit light of the second wavelength range compared to both light of the first wavelength range and light of the third wavelength range.

Note that the average transmittance in the first wavelength range is preferably 20% or less and more preferably 10% or less. Further, the average transmittance in the second wavelength range is preferably 80% or more. Further, the average transmittance in the third wavelength range is preferably 50% or less.

When the weight of the infrared light pass filter 12P is 100% by weight, the content of the ITO may be 10% by weight or more and 30% by weight or less. When the content of the ITO is 10% by weight or more, effectiveness in lowering the transmittance to light of the third wavelength range can be enhanced. Further, when the content of the ITO is 30% by weight or less, enlargement of the area of residue is suppressed in the patterning of the infrared light pass filter 12P.

The infrared light pass filter 12P may include two or more coloring layers. When the infrared light pass filter 12P includes two or more coloring layers, a thickness per layer can be reduced based on the premise that the total thickness of the infrared light pass filter 12P is the same, which can enhance adhesion among the colorant layers. The number of coloring layers may be, for example, two or more and six or less and preferably two or more and four or less.

When the infrared light pass filter 12P includes two or more coloring layers, all the coloring layers may be formed of a photosensitive coloring composition having the same makeup. Alternatively, two or more coloring layers may include a first layer formed of a photosensitive coloring composition having a first composition and a second layer formed of a photosensitive coloring composition having a second composition. The second composition is different from the first composition. The infrared light pass filter 12P may have a planarization layer positioned between the coloring layers. The planarization layer does not contain a colorant.

The total thickness of the infrared light pass filter 12P may be 0.3 µm or more and 5 µm or less and preferably 0.5 µm or more and 3 µm or less. The infrared light pass filter 12P may have, for example, a square shape, from a viewpoint facing a plane on which the infrared light pass filter 12P extends. In this case, the side length in the infrared light pass filter 12P, e.g., the pixel size of the infrared light pass filter 12P, may be 0.7 µm or more and 20 µm or less and more preferably 0.9 µm or more and 5 µm or less.

### [Coloring composition]

The coloring composition of the present disclosure includes: a colorant that absorbs visible light; indium tin oxide; and a polymerizable compound. In the total solid content of the coloring composition, the content of the indium tin oxide is 10% by weight or more and 30% by weight or less.

The colorant absorbs visible light. As described above, visible light is light in the range of 400 nm or more and 800 nm or less. The colorant may be a colorant that exhibits a black color. The colorant that exhibits a black color may be a colorant that exhibits a black color by itself. Alternatively, the colorant may contain two or more colorants that exhibit green, blue, red, yellow, violet, magenta, cyan, orange, and the like.

Examples of the colorant that exhibits a black color by itself may include a bisbenzofuranone-based pigment, an azomethine-based pigment, a perylene-based pigment, and an azo-based stain.

The colorant that exhibits a green color may be a green pigment, a green stain, or an intermediate thereof. Examples of the green pigment may include C.I. Pigment Green 7, 36, 37, and 58. Examples of the green stain may include C.I. Acid Green 25 and 41. These colorants may be used individually, or two or more colorants may be mixed.

The colorant that exhibits a blue color may include a blue pigment or a blue stain. Examples of the blue pigment may include C.I. Pigment Blue 15, 15:3, 15:4, 15:6, 6, 22, and 60. Examples of the blue stain may include C.I. Acid Blue 41, 83, 90, 113, and 129. These colorants may be used individually, or two or more colorants may be mixed.

The colorant that exhibits a red color may be a red pigment or a red stain. Examples of the red pigment may include C.I. Pigment Red 123, 155, 168, 177, 180, 217, 220, and 254. Examples of the red stain may include C.I. Acid Red 37, 50, 111, 114, 257, and 266. These colorants may be used individually, or two or more colorants may be mixed.

The colorant that exhibits a yellow color may be a yellow pigment or a yellow stain. Examples of the yellow pigment may include C.I. Pigment Yellow 138, 139, 150, and 185. Examples of the yellow stain may include C.I. Acid Yellow 17, 49, 67, 72, 127, and 110. These colorants may be used individually, or two or more colorants may be mixed.

The colorant that exhibits a violet color may be a violet pigment. Examples of the violet pigment may include C.I. Pigment Violet 1, 19, 23, 27, 29, 30, 32, 37, 40, 42, and 50. These colorants may be used individually, or two or more colorants may be mixed.

The colorant that exhibits a magenta color may be a magenta pigment. Examples of the magenta pigment may include C.I. Pigment Red 7, 14, 41, 48:1, 48:2, 48:3, 48:4, 81:1, 81:2, 81:3, 146, 177, 178, 184, 185, 187, 200, 202, 208, 210, 246, 254, 255, 264, 270, and 272. These colorants may be used individually, or two or more colorants may be mixed.

The colorant that exhibits a cyan color may be a cyan pigment. Examples of the cyan pigment may include C.I. Pigment Blue 15:1, 15:2, 15:3, 15:4, 15:6, 16, and 80. These colorants may be used individually, or two or more colorants may be mixed.

The colorant that exhibits an orange color may be an orange pigment. Examples of the orange pigment may include C.I. Pigment Orange 36, 43, 51, 55, 59, 61, 71, and 73. These colorants may be used individually, or two or more colorants may be mixed.

Examples of the infrared light absorbing dye may include an anthraquinone-based dye, a cyanine-based dye, a phthalocyanine-based dye, a dithiol-based dye, a diimonium-based dye, a squarylium-based dye, and a croconium-based dye.

As described above, the coloring composition contains ITO. The ITO may have a particulate shape. The particle diameter, i.e., the median diameter, of the ITO particles is preferably 10 nm or more and 100 nm or less. When the median diameter is 10 nm or more, the ITO particles are prevented from being excessively fine, which prevents the ITO particles from becoming difficult to disperse in a dispersion liquid in which the ITO particles disperse. When the median diameter is 100 nm or less, the ITO particles are prevented from being excessively large, which prevents the accuracy in the shape of the infrared light pass filter from deteriorating when the infrared light pass filter has been patterned.

As described above, it is preferable that in the total solid content of the coloring composition, the content rate of the ITO is 10% by weight or more and 30% by weight or less and is preferably 15% by weight or more and 25% by weight or less. When the content rate of the ITO is 10% by weight or more, it is possible to lower the average transmittance in light of the third wavelength range. Further, when the content rate of the ITO is 30% by weight or less, enlargement of the area of the residue in the infrared light pass filter 12P is suppressed when the infrared light pass filter has been patterned by photolithography. In this manner, when the content rate of the ITO is 10% by weight or more and 30% by weight or less, it is possible to strike a balance between enhancing the selectivity to wavelengths in the infrared light pass filter 12P and enhancing the accuracy in the shape of the infrared light pass filter 12.

Note that the ITO has a property of absorbing light of the second wavelength range. However, the absorptivity at which the ITO absorbs light of the second wavelength range is drastically lower than the absorptivity at which it absorbs light of the third wavelength range. However, if the content rate of the ITO increases, the content rate of the ITO causes lowering of the transmittance in light of the second wavelength range. In this regard, when the content rate of the ITO is 30% by weight or less, lowering of the transmittance of light of the second wavelength range is also suppressed in the infrared light pass filter. Further, the residue in the infrared light pass filter is the unexposed portion neighboring the exposed portion of the coating film for forming the infrared light pass filter when the coating film has been patterned by a photolithographic method and is continuous with the exposed portion even after development.

An example of the polymerizable compound may be an acryl monomer. The polymerizable compound may contain a trifunctional acryl monomer. When the polymerizable compound contains a trifunctional acryl monomer, it is possible to enhance the sensitivity of the coloring composition during exposure to light. Examples of the polymerizable compound may include pentaerythritol triacrylate, pentaerythritol tetraacrylate, trimethylolpropane triacrylate, trimethylolpropane PO-modified (n = 1) triacrylate, trimethylolpropane PO-modified (n = 2) triacrylate, trimethylolpropane EO-modified (n = 1) triacrylate, trimethylolpropane EO-modified (n = 2) triacrylate, dipentaerythritol pentaacrylate, dipentaerythritol hexaacrylate, pentaerythritol tetraacrylate, ditrimethylolpropane tetraacrylate, isocyanuric acid EO-modified diacrylate, and isocyanuric acid EO-modified triacrylate. These polymerizable compounds may be used individually, or two or more polymerizable compounds may be mixed.

Note that pentaerythritol triacrylate, trimethylolpropane triacrylate, trimethylolpropane PO-modified (n = 1) triacrylate, trimethylolpropane PO-modified (n = 2) triacrylate, trimethylolpropane EO-modified (n = 1) triacrylate, trimethylolpropane EO-modified (n = 2) triacrylate, and isocyanuric acid EO-modified triacrylate, among the above-described polymerizable compounds, are trifunctional acryl monomers.

The binder resin is obtained by copolymerizing at least one of a monomer and an oligomer. The monomer and the oligomer are raw materials of the binder resin, and the binder resin may be formed with two or more raw materials. The monomer for forming the binder resin and the monomer constituting the oligomer for forming the binder resin may be (meth)acrylic acid ester, (meth)acrylic acid, styrene, vinyl acetate, hydroxyethyl vinyl ether, ethylene glycol divinyl ether, pentaerythritol trivinyl ether, (meth)acrylamide, N-hydroxymethyl (meth)acrylamide, N-vinylformamide, acrylonitrile, or the like.

Examples of the (meth)acrylic acid ester may include methyl (meth)acrylate, ethyl (meth)acrylate, 2-hydroxyethyl (meth)acrylate, 2-hydroxypropyl (meth)acrylate, cyclohexyl (meth)acrylate, β-carboxyethyl (meth)acrylate, diethylene glycol di(meth)acrylate, 1,6-hexanediol di(meth)acrylate, triethylene glycol di(meth)acrylate, tripropylene glycol di(meth)acrylate, trimethylolpropane tri(meth)acrylate, pentaerythritol tri(meth)acrylate, glycidyl (meth)acrylate, 1,6-hexanediol diglycidyl ether di(meth)acrylate, bisphenol A diglycidyl ether di(meth)acrylate, neopentyl glycol diglycidyl ether di(meth)acrylate, dipentaerythritol hexa(meth)acrylate, tricyclodecanyl (meth)acrylate, ester acrylate, (meth)acrylic acid ester of methylolated melamine, epoxy (meth)acrylate, and urethane acrylate.

The binder resin is preferably generated by copolymerization of a monomer having an acid group. Accordingly, the binder resin can dissolve in an alkaline developer. The acid group may be a carboxyl group. The carboxyl group-containing monomer only has to have at least one carboxyl group. The carboxyl group-containing monomer may be unsaturated monocarboxylic acid or unsaturated polycarboxylic acid. Examples of the unsaturated polycarboxylic acid may include unsaturated dicarboxylic acid and unsaturated tricarboxylic acid.

Examples of the unsaturated monocarboxylic acid may include acrylic acid, methacrylic acid, crotonic acid, α-chloracrylic acid, and cinnamic acid. Examples of the unsaturated dicarboxylic acid may include maleic acid, fumaric acid, itaconic acid, citraconic acid, and mesaconic acid. The unsaturated polycarboxylic acid may be an acid anhydride thereof. The acid anhydride of the unsaturated polycarboxylic acid may be maleic anhydride, itaconic anhydride, citraconic anhydride, or the like. The unsaturated polycarboxylic acid may be a mono(2-methacryloyloxyalkyl) ester thereof. Examples of the mono(2-methacryloyloxyalkyl) ester of the unsaturated polycarboxylic acid may include mono(2-acryloyloxyethyl) succinate, mono(2-methacryloyloxyethyl) succinate, mono(2-acryloyloxyethyl) phthalate, and mono(2-methacryloyloxyethyl) phthalate. The unsaturated polycarboxylic acid may be mono(meth)acrylates of dicarboxylic polymers positioned at both terminals thereof. Examples of the mono(meth)acrylate of the dicarboxylic polymer of the unsaturated polycarboxylic acid may include ω-carboxypolycaprolactone monoacrylate and ω-carboxypolycaprolactone monomethacrylate. These carboxyl group-containing monomers may be used individually, or two or more carboxyl group-containing monomers may be mixed.

The weight average molecular weight of the binder resin is preferably 5000 or more and 20000 or less. When the weight average molecular weight is 5000 or more, the coloring composition is sufficiently cured in the exposed portion during patterning of the coating film by a photolithographic method and accordingly can contain a compound having a large molecular weight such that accuracy in the pattern shape is enhanced. The weight average molecular weight being 20000 or less suppresses lowering of developing properties for a developer used in a photolithographic method and accordingly suppresses lowering of accuracy in the pattern shape.

The binder resin may be a thermosetting resin. Examples of the thermosetting resin may include an epoxy resin, a benzoguanamine resin, a rosin-modified maleic acid resin, a rosin-modified fumaric acid resin, a melamine resin, a urea resin, and a phenol resin. These thermosetting resins may be used individually, or two or more thermosetting resins may be mixed.

The photopolymerization initiator is preferably an oxime ester-based photopolymerization initiator and an α-aminoalkylphenone-based photopolymerization initiator and more preferably an oxime ester-based photopolymerization initiator. The oxime ester-based photopolymerization initiator has high sensitivity to exposure light and accordingly can reduce the content rate of the photopolymerization initiator in the photosensitive coloring composition. The oxime ester-based photopolymerization initiator may be 1,2-octanedione, 1-[4-(phenylthio)phenyl-2-(O-benzoyloxime)], ethanone, 1-[9-ethyl-6-(2-methylbenzoyl)-9H-carbazole-3-yl]-, 1-(O-acetyloxime), or the like.

The α-aminoalkylphenone-based photopolymerization initiator may be 2-benzyl-2-dimethylamino-1-(4-morpholinophenyl)-butanone-1, 2-dimethylamino-2-(4-methyl-benzyl)-1-(4-morpholine-4-yl-phenyl)-butane-1-one, or the like.

The photopolymerization initiator may contain, in addition to the oxime ester-based photopolymerization initiator and the α-aminoalkylphenone-based photopolymerization initiator, other photopolymerization initiators. Examples of the other photopolymerization initiators may include an acetophenone-based photopolymerization initiator, a benzoin-based photopolymerization initiator, a benzophenone-based photopolymerization initiator, a thioxanthone-based photopolymerization initiator, a triazine-based photopolymerization initiator, a borate-based photopolymerization initiator, a carbazole-based photopolymerization initiator, and an imidazole-based photopolymerization initiator.

Examples of the acetophenone-based photopolymerization initiator may include 4-phenoxydichloroacetophenone, 4-t-butyl-dichloroacetophenone, diethoxyacetophenone, 1-(4-isopropylphenyl)-2-hydroxy-2-methylpropan-1-one, 1-hydroxycyclohexylphenylketone, and 2-methyl-1-[4-(methylthio)phenyl]-2-morpholinopropane-1-one.

The benzoin-based photopolymerization initiator may be benzoin, benzoin methyl ether, benzoin ethyl ether, benzoin isopropyl ether, benzyl dimethyl ketal, or the like.

The benzophenone-based photopolymerization initiator may be benzophenone, benzoylbenzoic acid, methyl benzoylbenzoate, 4-phenylbenzophenone, hydroxybenzophenone, acrylated benzophenone, 4-benzoyl-4'-methyldiphenyl sulfide, or the like.

The thioxanthone-based photopolymerization initiator may be thioxanthone, 2-chlorothioxanthone, 2-methylthioxanthone, isopropyl thioxanthone, and 2,4-diisopropyl thioxanthone, or the like.

The triazine-based photopolymerization initiator may be 2,4,6-trichloro-s-triazine, 2-phenyl4,6-bis(trichloromethyl)-s-triazine, 2-(p-methoxyphenyl-4,6-bis(trichloromethyl)-s-triazine, 2-(p-tolyl)-4,6-bis(trichloromethyl)-s-triazine, 2-piperonyl-4,6-bis(trichloromethyl)-s-triazine, 2,4-bis(trichloromethyl)-6-styryl-chloromethyl)-s-triazine, 2,4-bis(trichloromethyl)-6-styryl-s-triazine, 2-(naphtho-1-yl)-4,6-bis(trichloromethyl)-s-triazine, 2-(4-methoxy-naphtho-1-yl)-4,6-bis(trichloromethyl)-s-triazine, 2,4-trichloromethyl(piperonyl)-6-triazine, 2,4-trichloromethyl(4'-methoxystyryl)-6-triazine, or the like.

These photopolymerization initiators may be used individually, or two or more photopolymerization initiators may be mixed.

The coloring composition further contains a solvent in which the above-described materials are dissolved or dispersed. Examples of the solvent may include cyclohexane, cyclohexanone, ethyl cellosolve acetate, tetrahydrofuran, butyl cellosolve acetate, 1-methoxy-2-propyl acetate, diethylene glycol dimethyl ether, propylene glycol monomethyl ether acetate, ethyl benzene, ethylene glycol diethyl ether, xylene, ethyl cellosolve, methyl-n-amyl ketone, propylene glycol monomethyl ether toluene, methyl ethyl ketone, ethyl acetate, methanol, ethanol, isopropyl alcohol, butanol, isobutyl ketone, or a petroleum-based solvent. These solvents may be used individually, or two or more solvents may be mixed.

The coloring composition may contain an additive other than the above-described materials. An example of the additive may be at least one of a polymerization inhibitor, a surfactant, and a storage stabilizer.

The polymerization inhibitor may be a quinone-based inhibitor, a hindered phenol-based inhibitor, a nitrosoamine-based inhibitor, a phenothiazine-based inhibitor, or the like. These polymerization inhibitors may be used individually or in a state of a mixture that contains two or more thereof.

The surfactant may be an anionic surfactant, a nonionic surfactant, a cationic surfactant, an ampholytic surfactant, and a silicon-based surfactant. Examples of the anionic surfactant may include sodium lauryl sulfate, polyoxyethylene alkyl ether sulfate, sodium dodecyl benzene sulfonate, alkali salt of a styrene-acrylic acid copolymer, sodium stearate, sodium alkyl naphthalene sulfonate, sodium alkyl diphenyl ether disulfonate, monoethanolamine lauryl sulfate, triethanolamine lauryl sulfate, ammonium lauryl sulfate, monoethanolamine stearate, sodium stearate, sodium lauryl sulfate, monoethanolamine derivative of a styrene-acrylic acid copolymer, and polyoxyethylene alkyl ether phosphate ester.

Examples of the nonionic surfactant may include polyoxyethylene oleyl ether, polyoxyethylene lauryl ether, polyoxyethylene nonyl phenyl ether, polyoxyethylene alkyl ether phosphate ester, polyoxyethylene sorbitan monostearate, and polyethylene glycol monolaurate. Examples of the cationic surfactant may include alkyl quaternary ammonium salt and an ethylene oxide adduct thereof. Examples of the ampholytic surfactant may include alkyl betaine such as betaine alkyldimethylaminoacetate, and alkyl imidazoline. These surfactants may be used individually, or two or more surfactants may be mixed.

Examples of the storage stabilizer may include quaternary ammonium chloride, organic acid, methyl ether of organic acid, T-butylcatechol, organic phosphine, and phosphite. The quaternary ammonium chloride may be benzyl trimethyl chloride, diethyl hydroxyamine, or the like. The organic acid may be lactic acid, oxalic acid, or the like. The organic phosphine may be triethyl phosphine, triphenyl phosphine, or the like. These storage stabilizers may be used individually, or two or more storage stabilizers may be mixed.

### [Production method of coloring composition]

In producing the coloring composition, for example, a colorant is dispersed in a solvent to generate a colorant dispersion. Subsequently, the colorant dispersion is mixed with a polymerizable compound, a binder resin, a photopolymerization initiator, a polymerization inhibitor, and a solvent to generate a mixed solution. The mixed solution can be stirred for a prescribed time and thereafter filtered to obtain a coloring composition.

### [Test Examples]

### [Generation of colorant dispersion]

A colorant, a dispersant, and a solvent were mixed at the ratios described below and thereafter stirred to generate a mixed solution.

Colorant: manufactured by BASF, Lumogen BlackK0088 (perylene-based pigment, solid content amount 100% by weight): 12.0 parts (Lumogen is a registered trademark.)
Dispersant: manufactured by BYK Japan KK, Disperbyk-2001 (solid content amount 46% by weight): 17.4 parts (Disperbyk is a registered trademark.)
Solvent: propylene glycol monomethyl ether acetate: 70.6 parts

Thereafter, the mixed solution was subjected to a dispersing treatment over 1.5 hours using zirconia beads having a diameter of 0.1 mm in a Disper disperser (manufactured by Eko Instruments Co., Ltd., DISPERMAT LC55). Subsequently, the mixed solution was filtered through a 5 µm filter to obtain a colorant dispersion.

### [Synthesis of binder resin]

Sixty parts by weight of propylene glycol monomethyl ether acetate, 32 parts by weight of benzyl methacrylate, 8 parts by weight of methacrylic acid, and 0.60 parts by weight of benzoyl peroxide were prepared. These were put in a reaction vessel in which a stirrer and a reflux tube are installed, and subjected to stirring and flux for 8 hours under heating to 80°C while introducing nitrogen gas into the reaction vessel. Accordingly, a binder resin was obtained.

### [Liquid preparation of coloring composition]

At the ratios illustrated in Table 1and Table 2 below, a colorant dispersion, a polymerizable compound, a binder resin, a photopolymerization initiator, and a solvent were mixed to obtain a mixed solution. Subsequently, the mixed solution was stirred over 1 hour and thereafter filtered through a 0.45 µm filter to obtain each coloring composition.

In Table 1 to Table 3 below, the ITO, the polymerizable compound, the photopolymerization initiator, and the solvent are as described below.
ITO: manufactured by Merck, 7004600, median diameter 88.4 nm, solid content amount 30% by weight
Polymerizable compound: manufactured by Toagosei Co., Ltd., M-350 (trimethylolpropane EO-modified (n = 1) triacrylate, trifunctional, weight average molecular weight 428.5, solid content amount 100% by weight)
Photopolymerization initiator: manufactured by BASF, OXE-02 (solid content amount 100% by weight)
Solvent: propylene glycol monomethyl ether acetate

The content rate of the ITO in the total solid content of the coloring composition is the percentage of the weight of the ITO to the sum of the weight of the colorant, the weight of the solid content in the dispersant, the weight of the solid content in the ITO, the weight of the polymerizable compound, the weight of the binder resin, and the weight of the photopolymerization initiator. Note that the weight of the binder resin described in Table 1 and Table 2 is the weight of only the solid content.

**[Table 1]**

| | Coloring composition 1 | Coloring composition 2 | Coloring composition 3 | Coloring composition 4 |
|---|---|---|---|---|
| Dispersion (parts by weight) | 64.79 | 59.88 | 59.63 | 56.24 |
| ITO (parts by weight) | 6.17 | 8.32 | 11.90 | 14.35 |
| Polymerizable compound (parts by weight) | 1.34 | 1.31 | 1.34 | 1.32 |
| Binder resin (parts by weight) | 1.13 | 1.11 | 1.13 | 1.12 |
| Photopolymerization initiator (parts by weight) | 0.34 | 0.33 | 0.34 | 0.33 |
| Solvent (parts by weight) | 26.23 | 29.05 | 25.66 | 26.64 |
| Total | 100.0 | 100.0 | 100.0 | 100.0 |
| Content rate of ITO (%) | 10.5 | 14.5 | 19.5 | 23.5 |

**[Table 2]**

| | Coloring composition 5 | Coloring composition 6 | Coloring composition 7 | Coloring composition 8 |
|---|---|---|---|---|
| Dispersion (parts by weight) | 53.49 | 70.83 | 71.94 | 48.58 |
| ITO (parts by weight) | 18.82 | - | 3.03 | 22.39 |
| Polymerizable compound (parts by weight) | 1.33 | 1.36 | 1.40 | 1.31 |
| Binder resin (parts by weight) | 1.12 | 1.14 | 1.16 | 1.11 |
| Photopolymerization initiator (parts by weight) | 0.33 | 0.34 | 0.35 | 0.33 |
| Solvent (parts by weight) | 24.91 | 26.33 | 22.12 | 26.28 |
| Total | 100.0 | 100.0 | 100.0 | 100.0 |
| Content rate of ITO (%) | 29.5 | 0.0 | 5.0 | 35.0 |

### [Evaluation of spectral characteristics]

### [Production of substrate for testing]

Each coloring composition was applied onto a glass substrate using a spin coater such that the thickness after baking treatment was 1.5 µm, to thereby form a coating film. Subsequently, the coating film on the glass substrate was subjected to a baking treatment for 2 minutes using a hot plate set at 100°C, to thereby form an infrared light pass filter. Accordingly, substrates for testing of Test Example 1-1 to Test Example 1-8 were obtained.

**[Table 3]**

| | Coloring composition | Film thickness (µm) |
|---|---|---|
| Test Example 1-1 | Coloring composition 1 | 1.5 |
| Test Example 1-2 | Coloring composition 2 | 1.5 |
| Test Example 1-3 | Coloring composition 3 | 1.5 |
| Test Example 1-4 | Coloring composition 4 | 1.5 |
| Test Example 1-5 | Coloring composition 5 | 1.5 |
| Test Example 1-6 | Coloring composition 6 | 1.5 |
| Test Example 1-7 | Coloring composition 7 | 1.5 |
| Test Example 1-8 | Coloring composition 8 | 1.5 |

### [Evaluation method]

For the infrared light pass filter included by the substrate for testing of each Test Example, the transmittance in the wavelength region of 400 nm or more and 2500 nm or less was measured using a spectrophotometer (manufactured by Hitachi High-Technologies Corporation, U-4100). The measurement result of the transmittance was as illustrated in Table 4. Note that Table 4 illustrates the average transmittance in a first wavelength range of 400 nm or more and 800 nm or less, the average transmittance in a second wavelength range of 900 nm or more and 1100 nm or less, and the average transmittance in a third wavelength range of 1300 nm or more and 2500 nm or less.

### [Evaluation results]

For the infrared light pass filter included by the substrates for testing of Test Example 1-1 to Test Example 1-8, the results of measuring the average transmittance in each wavelength range were as illustrated in Table 4 below.

**[Table 4]**

| | Average transmittance (%) | | |
|---|---|---|---|
| | First wavelength range | Second wavelength range | Third wavelength range |
| Test Example 1-1 | 7.4 | 83.2 | 53.1 |
| Test Example 1-2 | 7.6 | 81.5 | 44.3 |
| Test Example 1-3 | 7.9 | 80.1 | 33.2 |
| Test Example 1-4 | 8.3 | 78.8 | 24.8 |
| Test Example 1-5 | 8.6 | 76.4 | 12.1 |
| Test Example 1-6 | 4.7 | 86.1 | 85.9 |
| Test Example 1-7 | 6.9 | 84.7 | 63.1 |
| Test Example 1-8 | 8.9 | 74.8 | 1.8 |

As shown in Table 4, it was found that in the infrared light pass filters of Test Example 1-1 to Test Example 1-8, the average transmittance in the first wavelength range was in the range of 4.7% or more and 8.9% or less, and the average transmittance in the second wavelength range was in the range of 74.8% or more and 86.1% or less. It was found that the average transmittance in the second wavelength range was 75% or more in the infrared light pass filters of Test Example 1-1 to Test Example 1-7 but was less than 75% in the infrared light pass filter of Test Example 1-8.

Further, it was found that in the infrared light pass filters of Test Example 1-1 to Test Example 1-8, the average transmittance in the third wavelength range was in the range of 1.8% or more and 85.9% or less. It was found that the average transmittance in the third wavelength range was 55% or less in Test Example 1-1 to Test Example 1-5 and Test Example 1-8 while being more than 55% in Test Example 1-6 and Test Example 1-7.

### [Evaluation regarding shape]

### [Production of substrate for testing]

Firstly, a silicon wafer having a planarization layer was prepared. Subsequently, each coloring composition was applied onto the planarization layer using a spin coater such that the thickness after baking treatment was 1.5 µm, to thereby form a coating film. Subsequently, the coating film on the planarization layer was subjected to a baking treatment for 2 minutes using a hot plate set at 100°C. Thereafter, the coating film was exposed using a photomask capable of forming a square pattern having a side length, i.e., a pixel size, of 3.0 µm and using an exposure device (manufactured by Canon Inc., FPA-5510IZ). A photomask used in the exposure is capable of exposing only the position corresponding to one pixel assigned to the infrared light pass filter among four pixels contained in two rows and two columns, in pixels tightly arranged along the row direction and the column direction.

Thereafter, the coating film after exposure was developed with a 0.2% tetraammonium hydroxide aqueous solution. Subsequently, the coating film after development was sequentially subjected to washing with water and drying to form an infrared light pass filter including 1000 pixels having a pixel size of 3.0 µm. Accordingly, substrates for testing of Test Example 2-1 to Test Example 2-8 were obtained.

### [Evaluation method]

Using a scanning electron microscope (manufactured by Hitachi High-Technologies Corporation, s-4800), the substrate for testing of each Test Example was observed at a magnification of 2000x. Then, a straight line was drawn along the boundary between the infrared light pass filter formed on each substrate for testing and a region of the planarization layer where the coloring composition was removed. The straight line was drawn such that the pixel size of the infrared light pass filter was 3.0 µm. Subsequently, the residue in the infrared light pass filter, which is a portion extending from the straight line toward the planarization layer, and the planarization layer were binarized. Then, the area of the residue was calculated, and thereafter the percentage of the area of the residue to the area of the pixels formed at a site in the planarization layer where the residue was positioned. That is, the percentage of the area of the residue to 9.0 µm² was calculated. For each Test Example, the percentage of the area of the residue to the area of the pixels was calculated for residues at 20 locations, and the average value of the percentages in the residues at 20 locations was set to the percentage of the area of the residue to the area of the pixels in the Test Example.

### [Evaluation results]

For the infrared light pass filters included by the substrates for testing of Test Example 2-1 to Test Example 2-8, the results of calculating the percentage of the area of the residue to the area of the aperture were as illustrated in Table 5 below.

**[Table 5]**

| | Coloring composition | Residue (%) |
|---|---|---|
| Test Example 2-1 | Coloring composition 1 | 0.3 |
| Test Example 2-2 | Coloring composition 2 | 0.5 |
| Test Example 2-3 | Coloring composition 3 | 0.8 |
| Test Example 2-4 | Coloring composition 4 | 1.4 |
| Test Example 2-5 | Coloring composition 5 | 2.7 |
| Test Example 2-6 | Coloring composition 6 | 0.1 |
| Test Example 2-7 | Coloring composition 7 | 0.2 |
| Test Example 2-8 | Coloring composition 8 | 6.5 |

As shown in Table 5, it was found that the area of the residue is less than 1% in the infrared light pass filters of Test Example 2-1 to Test Example 2-3, Test Example 2-6, and Test Example 2-7 while being 1.4% in the infrared light pass filter of Test Example 2-4. Further, it was found that the area of the residue is 2.7% in the infrared light pass filter of Test Example 2-5 and 6.5% in the infrared light pass filter of Test Example 2-8.

Fig. 2 is a graph illustrating a relationship between the content rate of the ITO and the area of the residue and a graph illustrating a relationship between the content rate of the ITO and the average transmittance in the third wavelength range. Note that in Fig. 2, the relationship between the content rate of the ITO and the third wavelength range is indicated by triangles, and the relationship between the content rate of the ITO and the area of the residue is indicated by circles.

As shown in Fig. 2, it was found that when the content rate of the ITO is in the range of 10% by weight or more and 30% by weight or less, it is possible to strike a balance between suppressing an increase in the average transmittance in the third wavelength range and suppressing enlargement of the residue of the infrared light pass filter. Note that the content rate of the ITO is preferably in the range of 10.5% by weight or more and 29.5% by weight or less.

Further, it was found that when it is required to further suppress the enlargement of the residue of the infrared light pass filter, the upper limit value in the content rate of the ITO is more preferably 23.5% by weight or less and further preferably 19.5% by weight or less.

As described above, the effects described below can be obtained according to an embodiment in the infrared light pass filter, the coloring composition, the filter for solid-state image sensors, and the solid-state image sensor.

(1) The infrared light pass filter 12P contains an ITO so that the average transmittance in the third wavelength range can be lowered. Accordingly, the infrared light pass filter 12P can selectively transmit light of the second wavelength range compared to both light of the first wavelength range and light of the third wavelength range.
(2) When the content of the ITO is 10% by weight or more, effectiveness in lowering the transmittance to light of the third wavelength range can be enhanced. Further, when the content of the ITO is 30% by weight or less, enlargement of the area of residue is suppressed in the patterning of the infrared light pass filter 12P.
(3) When the content rate of the ITO is 10% by weight or more and 30% by weight or less, it is possible to strike a balance between enhancing the selectivity of a wavelength in the infrared light pass filter 12P and enhancing the accuracy in the shape of the infrared light pass filter 12.
(4) When the polymerizable compound contains a trifunctional acryl monomer, it is possible to enhance the sensitivity of the coloring composition during exposure to light.
(5) The oxime ester-based photopolymerization initiator has high sensitivity to exposure light and accordingly can reduce the content rate of the photopolymerization initiator in the coloring composition.

## Claims

1. An infrared light pass filter comprising:
a colorant;
an indium tin oxide; and
a polymer, wherein
an average transmittance in a first wavelength range of 400 nm or more and 800 nm or less is 30% or less,
an average transmittance in a second wavelength range of 900 nm or more and 1100 nm or less is 75% or more, and
an average transmittance in a third wavelength range of 1300 nm or more and 2500 nm or less is 55% or less.

2. The infrared light pass filter according to claim 1,
wherein when a weight of the infrared light pass filter is 100% by weight,
a content rate of the indium tin oxide is 10% by weight or more and 30% by weight or less.

3. A coloring composition comprising:
a colorant that absorbs visible light;
an indium tin oxide; and
a polymerizable compound,
wherein in a total solid content of the coloring composition, a content rate of the indium tin oxide is 10% by weight or more and 30% by weight or less.

4. The coloring composition according to claim 3,
wherein the polymerizable compound contains a trifunctional acryl monomer.

5. The coloring composition according to claim 3 or 4, further comprising a photopolymerization initiator,
wherein the photopolymerization initiator is an oxime ester-based photopolymerization initiator.

6. A filter for solid-state image sensors comprising:
a color filter; and
the infrared light pass filter according to claim 1 or 2.

7. A solid-state image sensor comprising:
the filter for solid-state image sensors according to claim 6;
a first photoelectric conversion device covered by the color filter; and
a second photoelectric conversion device covered by the infrared light pass filter.
